# EUROPÄISCHE PATENTSCHRIFT

(11) **EP 1 113 362 B1**
(45) Veröffentlichungstag und Bekanntmachung des Hinweises auf die Patenterteilung: **20.10.2004**
(21) Anmeldenummer: 00126985.1
(22) Anmeldetag: 08.12.2000
(51) Int. Cl.: G06F 11/20, G11C 29/00

(54) **Integrierter Halbleiterspeicher mit einer Speichereinheit zum Speichern von Adressen fehlerhafter Speicherzellen**
Integrated semiconductor memory with a memory unit for storing addresses of faulty memory cells
Mémoire de semiconducteur intégrée avec une unité de mémoire pour le stockage des adresses de cellules de mémoire défectueuses

(30) Priorität: 29.12.1999 DE 19963689
(43) Veröffentlichungstag der Anmeldung: 04.07.2001
(73) Patentinhaber: Infineon Technologies AG, 81669 München (DE)
(72) Erfinder: Daehn, Wilfried, 29227 Celle (DE)
(74) Vertreter: Epping, Hermann, Fischer

(56) Entgegenhaltungen:
- EP-A- 0 424 612
- WO-A-98/03979
- US-A- 4 736 373
- US-A- 5 859 804
- US-A- 5 909 448

## Beschreibung

Die vorliegende Erfindung betrifft einen integrierten Halbleiterspeicher, der einem Speicherzellentest unterziehbar ist zur Ermittlung von funktionsfähigen und fehlerhaften Speicherzellen, mit einer Speichereinheit zum Speichern von Adressen von fehlerhaften Speicherzellen.

Integrierte Halbleiterspeicher weisen im allgemeinen zur Reparatur fehlerhafter Speicherzellen redundante Speicherzellen auf, die meist zu redundanten Reihenleitungen oder redundanten Spaltenleitungen zusammengefaßt sind, die reguläre Leitungen mit defekten Speicherzellen adressenmäßig ersetzen können. Dabei wird der integrierte Speicher beispielsweise mit einer externen Prüfeinrichtung oder einer Selbsttesteinrichtung geprüft und anschließend anhand einer sogenannten Redundanzanalyse eine Programmierung der redundanten Elemente vorgenommen. Eine Redundanzschaltung weist dann programmierbare Elemente z.B. in Form von programmierbaren Fuses auf, die zum Speichern der Adresse einer zu ersetzenden Leitung dienen.

Ein Halbleiterspeicherbaustein wird beispielsweise nach dem Herstellungsprozeß getestet und anschließend repariert. Hierzu werden die Adressen jener getesteter Speicherzellen, welche als fehlerhaft detektiert wurden, in einem sogenannten Fehleradreßspeicher gespeichert, um in einem anschließenden Schritt anhand der gespeicherten Adressen diese Speicherzellen durch fehlerfreie redundante Speicherzellen zu ersetzen. Der Speicherbaustein wird dabei im allgemeinen mehreren Tests unterzogen. Nur diejenigen Speicherzellen, welche alle Tests bestehen, gelten dabei als funktionsfähig bzw. fehlerfrei. Besteht eine Speicherzelle einen oder mehrere Tests nicht, so gilt sie als fehlerhaft und muß durch eine fehlerfreie redundante Speicherzelle ersetzt werden. Bei Halbleiterspeichern mit einem matrixförmigen Speicherzellenfeld, die redundante Reihenleitungen oder redundante Spaltenleitungen aufweisen, wird üblicherweise anstelle einer einzelnen Speicherzelle eine ganze Reihen- oder Spaltenleitung durch entsprechende redundante Reihen- oder Spaltenleitungen ersetzt.

Da Speicherzellen mehreren Tests unterzogen werden, ist bei Nichtbestehen eines Tests vor dem Speichern der Adresse einer fehlerhaften Speicherzelle, der sogenannten Fehleradresse, zu prüfen, ob die Fehleradresse bereits bei einem vorangegangenen Test gespeichert wurde. Ist dies der Fall, so soll die Fehleradresse nicht ein zweites Mal gespeichert werden, um Speicherplatz zu sparen. Die Speicherung der Fehleradressen kann in einem separaten Speicherzellenfeld auf dem zu prüfenden Chip erfolgen. Dieses zusätzliche Speicherzellenfeld ist dann Teil beispielsweise einer Selbsttesteinrichtung des Speicherchips.

Die durchzuführende Überprüfung, ob eine Speicherzelle bereits einmal gespeichert wurde, darf die Geschwindigkeit, mit welcher der Speichertest durchgeführt wird, nicht beeinflussen. Es kann dabei beispielsweise ein paralleler Vergleich aller schon gespeicherter Fehleradressen mit der aktuellen Fehleradresse und gegebenenfalls die anschließende Speicherung der neuen Adresse zusammen in einem Taktzyklus erfolgen. Dies führt jedoch im allgemeinen zu einem erheblichen Schaltungsaufwand für den vorzusehenden Fehleradreßspeicher. Ein serieller Vergleich der gespeicherten Fehleradressen mit der aktuellen Fehleradresse ist nur möglich, wenn sichergestellt werden kann, daß die Zeit vom Erkennen einer fehlerhaften Speicherzelle bis zum Erkennen der nächsten fehlerhaften Speicherzelle eine bestimmte Länge erreicht. Diese Zeit muß derart bemessen sein, daß vor dem Erkennen einer fehlerhaften Speicherzelle alle Vergleiche der bereits gespeicherten Fehleradressen mit der Adresse einer vorhergehenden fehlerhaften Speicherzelle und die eventuell erforderliche Speicherung der Adresse der vorhergehenden fehlerhaften Speicherzelle beendet sind. Da bei einem Speicherzellentest insbesondere entlang von Reihenleitungen bzw. Spaltenleitungen häufig fehlerhafte Speicherzellen in schneller Folge auftreten, kann die beschriebene Zeitspanne meist nicht eingehalten werden.

Sofern die Zahl defekter Speicherzellen klein ist im Vergleich zur Speichergröße, kann eine Speichereinheit als Zwischenspeicher vorgesehen werden, um einen Test des Speicherzellenfeldes und die Speicherung der Fehleradressen zu entkoppeln. Dieser Zwischenspeicher muß dabei groß genug sein, um zu gewährleisten, daß die Adressen von als fehlerhaft erkannten Speicherzellen jederzeit noch in den Zwischenspeicher geschrieben werden können. Die maximale Größe des vorzusehenden Zwischenspeichers kann anhand der Größe des zu testenden Speichers und der vorhandenen Anzahl von redundanten Reihen- und Spaltenleitungen abgeschätzt werden. Beispielsweise werden sämtliche Speicherzellen entlang einer Spaltenleitung und dabei so viele Spaltenleitungen getestet, bis feststeht, daß keine redundante Spaltenleitung mehr zur Reparatur von fehlerhaften Speicherzellen entlang einer Spaltenleitung zur Verfügung steht. Es ergibt sich so ein relativ hoher Speicherbedarf des vorzusehenden Zwischenspeichers. Für Speicherbausteine mit einer eingebauten Selbsttesteinheit ist eine derartige Lösung meist zu aufwendig.

Die Aufgabe der vorliegenden Erfindung ist es, einen Halbleiterspeicher, der einem Speicherzellentest unterziehbar ist, mit einer beschriebenen Speichereinheit zur Speicherung von Adressen fehlerhafter Speicherzellen anzugeben, bei dem der Speicherbedarf der Speichereinheit möglichst gering ist.

Die Aufgabe wird gelöst durch einen integrierten Halbleiterspeicher nach den Merkmalen des Patentanspruchs 1. Vorteilhafte Aus- und Weiterbildungen sind Gegenstand abhängiger Ansprüche. Die zweiteilige Form des Patentanspruchs 1 basiert auf einer Vorrichtung gemäß Dokument US-A- 5 859 804.

Der integrierte Halbleiterspeicher weist neben adressierbaren normalen Speicherzellen adressierbare redundante Speicherzellen zum Ersetzen einer der normalen Speicherzellen auf. Weiterhin weist der Speicher eine Speichereinheit zum Speichern von Adressen von fehlerhaften normalen Speicherzellen auf, mit einem Steuereingang zur Steuerung des Speichervorgangs der Speichereinheit und einem Ausgang zur Ausgabe des Speicherinhalts. Eine Vorverarbeitungseinrichtung weist eine Speichereinrichtung auf zur Speicherung einer festgelegten Anzahl von Adressen fehlerhafter normaler Speicherzellen. Sie dient zum Vergleich zwischen den gespeicherten Adressen und zur Ausgabe eines Ausgangssignals in Abhängigkeit des Vergleichsergebnisses. Die Vorverarbeitungseinrichtung weist ferner einen Ausgang zur Ausgabe des Ausgangssignals auf, der mit dem Steuereingang der Speichereinheit verbunden ist. Mit einer derartigen Schaltungsanordnung, in der im Zuge eines Speichertests Fehlerinformation in der Speichereinheit zwischengespeichert wird, kann die Größe der Speichereinheit gering gehalten werden.

Die Größe der Speichereinheit wird gering gehalten, indem bereits bei der Zwischenspeicherung in der Speichereinheit die Fehlerinformationen, welche für die an den Test anschließende Reparaturphase irrelevant sind, durch die Vorverarbeitungseinrichtung herausgefiltert und nicht mehr gespeichert werden. Der dazu durchgeführte Vergleich zwischen den in der Vorverarbeitungseinrichtung gespeicherten Fehleradressen erfolgt in geeigneter Weise in Hinblick darauf, welche der normalen Speicherzellen durch welche der redundanten Speicherzellen zu ersetzen sind. Es erfolgt also eine Art Vorverarbeitung der Fehlerinformation, die in Form von Adressen fehlerhafter Speicherzellen vorliegt, in Hinblick auf die nachfolgende Redundanzanalyse.

Die Adressen von Speicherzellen, welche in einem matrixförmigen Speicherzellenfeld angeordnet sind und zu adressierbaren Einheiten von Spaltenleitungen und Reihenleitungen zusammengefaßt sind, weisen bzw. einen ersten Adreßteil auf, über den auf die jeweilige Spaltenleitung zugegriffen wird, und einen zweiten Adreßteil, über den auf die jeweilige Reihenleitung zugegriffen wird. Dementsprechend weist die Speichereinrichtung der Vorverarbeitungseinrichtung beispielsweise Registereinheiten auf zur Speicherung jeweils eines der Adreßteile, die in Form eines Schieberegisters miteinander verbunden sind.

Gemäß einer Ausführungsform der Erfindung sind zum Vergleich zwischen den Inhalten der Registereinheiten die Ausgänge der Registereinheiten mit entsprechenden Eingängen einer Vergleichseinrichtung verbunden. Ein Ausgang der Vergleichseinrichtung ist mit dem Ausgang der Vorverarbeitungseinrichtung verbunden und damit mit dem Steuereingang zur Steuerung des Speichervorgangs der Speichereinheit.

Wie eingangs beschrieben, erfolgt die (dauerhafte) Speicherung von Fehleradressen aus mehreren durchzuführenden Tests beispielsweise in einem Fehleradreßspeicher, der sich in einem separaten Speicherzellenfeld auf dem zu prüfenden Halbleiterchip befindet. Dementsprechend weist die Schaltungsanordnung eine weitere Speichereinheit zum Speichern von Adressen von fehlerhaften normalen Speicherzellen auf, die mit dem Ausgang der Speichereinheit verbunden ist zur Übernahme einer der in der Speichereinheit gespeicherten Adressen.

Durch die erfindungsgemäße Schaltungsanordnung ist eine Filterung von Fehlerinformation bereits bei der Zwischenspeicherung in der Speichereinheit möglich, so daß eine relativ geringe Anzahl von Fehleradressen im Fehleradreßspeicher gespeichert werden muß. Dies kann einen erheblichen Zeitvorteil bei der nachfolgenden Redundanzanalyse beispielsweise in einer Selbsttesteinheit bedeuten, da eine vergleichsweise geringe Anzahl von Fehleradressen aus dem Fehleradreßspeicher verarbeitet werden muß.

Die Erfindung wird im folgenden anhand der in der Zeichnung dargestellten Figuren näher erläutert. Es zeigen:
- Figur 1: eine schematische Darstellung eines matrixförmigen Speicherzellenfeldes eines Halbleiterspeichers,
- Figur 2: ein Ausführungsbeispiel einer Schaltungsanordnung eines erfindungsgemäßen Halbleiterspeichers.

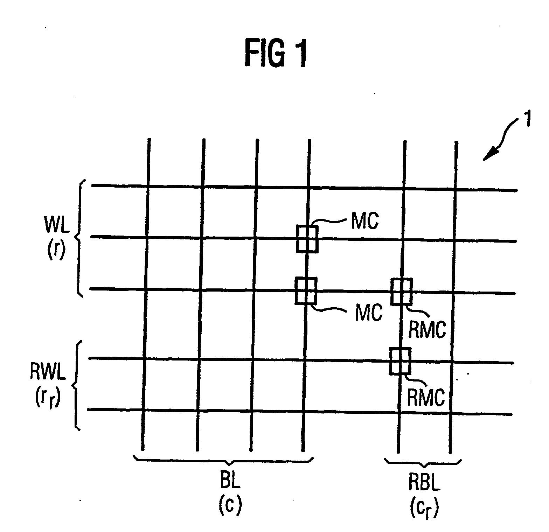

Figur 1 ist ein matrixförmig organisiertes Speicherzellenfeld 1 beispielsweise eines DRAM zu entnehmen, das reguläre Reihen- bzw. Wortleitungen WL, Spalten- bzw. Bitleitungen BL, redundante Wortleitungen RWL und redundante Bitleitungen RBL aufweist, in deren Kreuzungspunkten Speicherzellen MC bzw. redundante Speicherzellen RMC angeordnet sind. Die Speicherzellen MC bzw. RMC des gezeigten Speichers beinhalten jeweils einen Auswahltransistor und einen Speicherkondensator. Dabei sind Steuereingänge der Auswahltransistoren mit einer der Wortleitungen WL bzw. redundanten Wortleitungen RWL verbunden, während ein Hauptstrompfad der Auswahltransistoren zwischen dem Speicherkondensator der jeweiligen Speicherzelle MC bzw. RMC und einer der Bitleitungen BL bzw. RBL angeordnet ist.

Testsysteme, welche ein sogenanntes Fail Address Memory (FAM) verwenden, speichern wie oben beschrieben die Adressen fehlerhafter Speicherzellen MC des zu testenden Bausteins. Die maximale Größe des vorzusehenden Zwischenspeichers kann anhand der Größe des zu testenden Speicherzellenfeldes und der vorhandenen Anzahl von redundanten Bitleitungen und redundanten Wortleitungen abgeschätzt werden. Verfügt ein zu testendes Speicherzellenfeld beispielsweise über r Wortleitung WL und cr redundante Bitleitungen RBL, dann können bei einem Speichertest, welcher die Wortleitungen WL zuerst hoch- oder herunterzählt, bevor die Bitleitungsadresse inkrementiert bzw. dekrementiert wird, bis zu r·cr Fehleradressen auftreten, bevor feststeht, daß der Baustein nicht repariert werden kann. Umgekehrt gilt, daß bei einem Speicherzellenfeld mit c Bitleitungen BL und rr redundanten Wortleitungen RWL und einem Test, welcher die Bitleitungen BL zuerst hoch- oder herunterzählt, bevor die Wortleitungsadresse inkrementiert bzw. dekrementiert wird, bis zu c·rr Fehleradressen auftreten, bevor feststeht, daß der Baustein nicht repariert werden kann. Der Zwischenspeicher muß demzufolge die maximale Anzahl aus W = c·rr bzw. W = r·cr Fehleradressen aufnehmen können. Für beispielhafte Zahlenwerte r = 2048, rr = 24, c = 512, cr = 8 und eine Adreßtiefe von 24 Bit ergibt sich so eine Größe von 48 kByte. Für Speicherbausteine mit einer eingebauten Selbsttesteinheit ist eine derartige Lösung meist zu aufwendig.

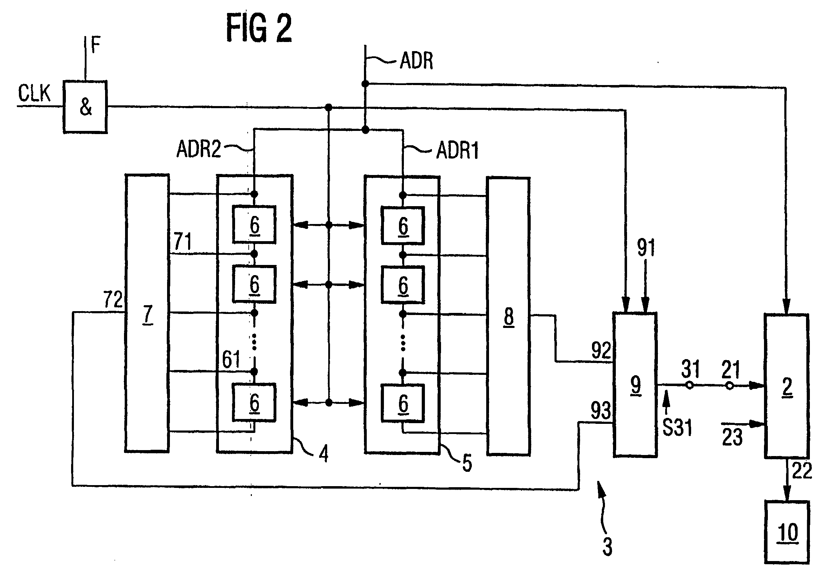

Figur 2 zeigt eine Ausführungsform einer erfindungsgemäßen Schaltungsanordnung. Diese weist eine Speichereinheit 2 auf zum Speichern von Adressen von fehlerhaften normalen Speicherzellen mit einem Steuereingang 21 zur Steuerung des Speichervorgangs der Speichereinheit 2 und einem Ausgang 22 zur Ausgabe des Speicherinhalts. Die Schaltungsanordnung weist ferner eine Vorverarbeitungseinrichtung 3 auf, die über den Ausgang 31 mit dem Steuereingang 21 der Speichereinheit 2 verbunden ist zur Ausgabe des Ausgangssignals S31. Der Speichereinheit 2 und der Vorverarbeitungseinrichtung 3 werden jeweils über einen Adreßbus Adressen ADR von fehlerhaften Speicherzellen MC zugeführt. Die Adressen umfassen dabei einen ersten Adreßteil ADR1, über den auf die jeweilige Bitleitung BL zugegriffen wird, und einen zweiten Adreßteil ADR2, über den auf die jeweilige Wortleitung WL zugegriffen wird.

Die Vorverarbeitungseinrichtung 3 weist Speichereinrichtungen 4 und 5 auf zur Speicherung einer festgelegten Anzahl von Adressen fehlerhafter normaler Speicherzellen MC. Jede der Speichereinrichtungen 4 und 5 weist Registereinheiten 6 auf zur Speicherung jeweils eines der Adreßteile ADR1 bzw. ADR2, die in Form eines Schieberegisters miteinander verbunden sind. Ausgänge 61 der Registereinheiten 6 sind mit Eingängen 71 einer Vergleichseinrichtung 7 verbunden. Der Ausgang 72 der Vergleichseinrichtung 7 ist mit dem Ausgang 31 der Vorverarbeitungseinrichtung 3 über die Steuerung 9 verbunden. Eine Vergleichseinrichtung 8 ist analog zu der Vergleichseinrichtung 7 mit entsprechenden Ausgängen der Speichereinrichtung 5 und über die Steuerung 9 mit dem Ausgang 31 der Vorverarbeitungseinrichtung 3 verbunden. Ein Signal 91 der Steuerung 9 dient zur Umschaltung zwischen den Signalen 92 und 93 als Eingangssignal der Steuerung 9. Das Taktsignal clk und das Signal F, das beispielsweise von einer Selbsttesteinheit erzeugt wird, dienen als Steuersignale zur Steuerung des Speichervorgangs der Speichereinrichtungen 4 und 5 sowie als Eingangssignale der Steuerung 9.

Die Schaltungsanordnung weist eine weitere Speichereinheit 10 auf, die zum Speichern von Adressen von fehlerhaften normalen Speicherzellen MC dient. Die weitere Speichereinheit 10 ist mit dem Ausgang 22 der Speichereinheit 2 verbunden zur Übernahme einer der in der Speichereinheit 2 gespeicherten Adressen. Die weitere Speichereinheit 10 dient beispielsweise als Fehleradreßspeicher zur Speicherung von Fehleradressen aus mehreren durchgeführten Funktionstests. Die weitere Speichereinheit 10 kann sich innerhalb oder außerhalb des Halbleiterspeichers befinden.

Im folgenden wird der Ablauf eines Funktionstests des Halbleiterspeichers und die damit verbundene Funktionsweise der in der Figur 2 dargestellten Schaltungsanordnung näher erläutert.

Es wird ein beispielhafter Funktionstest durchgeführt, durch welchen zunächst die Speicherzellen MC entlang einer Wortleitung WL geprüft werden, bevor die nächste Wortleitung WL bearbeitet wird. Es wird weiterhin zur Erläuterung von einem vollständigen Ausfall aller Speicherzellen MC entlang einer Wortleitung WL des Speicherzellenfeldes 1 ausgegangen. Infolge des Ausfalls einer Wortleitung WL erzeugt der Speichertest bei jedem Lesezugriff auf eine der Speicherzellen MC der zu testenden Wortleitung WL in schneller Folge eine neue Fehleradresse, welche zunächst in der Speichereinheit 2 abgelegt wird und anschließend in den Fehleradreßspeicher, der weiteren Speichereinheit 10, übertragen wird. Sobald mehr als cr Fehleradressen mit gleicher Wortleitungsadresse in der Speichereinheit 2 stehen, ist bereits festgelegt, daß eine nachfolgend festgestellte fehlerhafte Speicherzelle MC nur noch repariert werden kann, indem die entsprechende Wortleitung WL durch eine redundante Wortleitung RWL ersetzt wird. Um die fehlerhaften Speicherzellen MC durch redundante Bitleitungen RBL zu ersetzen, stehen nicht genug redundante Bitleitungen RBL zur Verfügung.

Für die sich an den Speichertest anschließende Redundanzanalyse, bei welcher festgelegt wird, welche Wortleitungen mit defekten Speicherzellen durch redundante Wortleitungen ersetzt werden, ist es daher irrelevant, ob in dem Fehleradreßspeicher cr+1 Fehleradressen mit identischer Wortleitungsadresse übernommen wurden oder mehr. Sobald die Speichereinheit 2 cr+1 Fehleradressen mit identischer Wortleitungsadresse enthält, müssen daher keine weiteren Fehleradressen mit dieser Wortleitungsadresse aufgenommen werden. Da die Fehleradressen mit identischer Wortleitungsadresse bei dem betrachteten Test immer in direkter Folge und nicht verteilt über die gesamte Testfolge auftreten, reicht es zu prüfen, ob die letzten cr+1 Fehleradressen die gleiche Wortleitungsadresse aufweisen. Ist dies der Fall, muß keine neue Fehleradresse mit gleicher Wortleitungsadresse mehr in die Speichereinheit 2 aufgenommen werden. Die Größe der Speichereinheit 2 ist damit auf die Größenordnung von cr+1 Fehleradressen beschränkt.

Bei einem derartigen Funktionstest werden also maximal die letzten cr+1 Fehleradressen in einer der Speichereinrichtungen 4 oder 5 der Vorverarbeitungseinrichtung 3 gespeichert. Beispielsweise wird in den Registereinheiten 6 der Speichereinrichtung 4 jeweils der Adreßteil ADR2 einer Fehleradresse abgespeichert, über den auf die jeweilige Wortleitung WL zugegriffen wird (Wortleitungsadresse). Die Inhalte der jeweiligen Registereinheiten 6, d.h. die letzten cr Wortleitungsadressen, plus der aktuellen Wortleitungsadresse werden über die Vergleichseinrichtung 7 auf Übereinstimmung geprüft. Stimmen diese Wortleitungsadressen überein, muß keine neue Fehleradresse mehr mit dieser Wortleitungsadresse in die Speichereinheit 2 aufgenommen werden. Dementsprechend wird über den Ausgang 31 der Speichervorgang der Speichereinheit 2 unterbrochen.

Bei einem Funktionstest, bei welchem zuerst die Wortleitungsadresse inkrementiert oder dekrementiert wird, bevor die Bitleitungsadresse verändert wird, erhält man durch analoge Überlegungen, daß maximal rr+1 Fehleradressen in der Speichereinheit 2 gespeichert werden müssen. Es ist also in der Vorverarbeitungseinrichtung 3 zu prüfen, ob die letzten rr+1 Fehleradressen die gleiche Bitleitungsadresse aufweisen. Dies geschieht mit der Speichereinrichtung 5 in Verbindung mit der Vergleichseinrichtung 8 bezüglich des Adreßteils ADR1 (Bitleitungsadresse). Es erfolgt ein paralleler Vergleich der aktuellen Bitleitungsadresse ADR1 mit den letzten rr-Adressen, die in der Speichereinrichtung 5 gespeichert sind.

Die Größe der Speichereinheit 2 beschränkt sich für beide Arten von Funktionstests auf die Größenordnung des maximalen Werts aus W = rr+1 bzw. W = cr+1. Um bei einer sogenannten Worst-Case-Betrachtung die Funktionsfähigkeit gewährleisten zu können, ist die Speichereinheit 2 zweckmäßigerweise auf das Doppelte des maximalen Wertes W zu bemessen. Ein derartiger Worst Case tritt beispielsweise auf, wenn entlang einer Wortleitung WL die zuletzt getesteten Speicherzellen MC fehlerhaft sind und nach dem Inkrement bzw. Dekrement der Wortleitungsadresse die zuerst getesteten Speicherzellen MC der nächsten Wortleitung fehlerhaft sind. Für das obige Zahlenbeispiel reduziert sich der Speicherplatzbedarf der Speichereinheit 2 damit auf die Größenordnung von 150 Byte.

Mit dem Steuersignal 91 wird ausgewählt, ob die Wortleitungsadressen ADR2, Bitleitungsadressen ADR1 oder beide Teile der Fehleradressen auf Übereinstimmung geprüft werden, beispielsweise infolge einer veränderten Redundanzanalyse. Über die Signale F und clk wird beispielsweise der Zeitpunkt des Speichervorgangs bzw. die diesbezügliche Taktrate gesteuert. Über den Steuereingang 23 der Speichereinheit 2 wird die Übernahme einer in der Speichereinheit 2 gespeicherten Adresse in die weitere Speichereinheit 10 gesteuert.

## Patentansprüche

1. Integrierter Halbleiterspeicher, der einem Speicherzellentest unterziehbar ist zur Ermittlung von funktionsfähigen und fehlerhaften Speicherzellen, mit
- adressierbaren normalen Speicherzellen (MC),
- adressierbaren redundanten Speicherzellen (RMC) zum Ersetzen einer der normalen Speicherzellen (MC),
- mit einer Testschaltung umfassend
- Mittel zur Ermittlung von Adressen von fehlerhaften normalen Speicherzellen,
- eine Speichereinheit (2) zum Speichern von Adressen (ADR) von fehlerhaften normalen Speicherzellen (MC) **dadurch gekennzeichnet dass** die Speichereinheit (2) mit einem Steuereingang (21) zur Steuerung des Speichervorgangs der Speichereinheit (2) und einem Ausgang (22) zur Ausgabe des Speicherinhaltsverbunden ist, und dass
- eine Vorverarbeitungseinrichtung (3) mit wenigstens einer Speichereinrichtung (4, 5) zur Speicherung einer festgelegten Anzahl von Adressen (ADR) fehlerhafter normaler Speicherzellen (MC), mit einer Vergleichseinrichtung (7, 8) zum Vergleich zwischen den in der Speichereinrichtung gespeicherten Adressen (ADR) und mit einem Ausgang (31) zur Ausgabe eines Ausgangssignals (S31) in Abhängigkeit des Vergleichsergebnisses, der mit dem Steuereingang (21) der Speichereinheit (2) verbunden ist, vorhanden ist.

2. Integrierter Halbleiterspeicher nach Anspruch 1,
**dadurch gekennzeichnet, daß**
- die Speicherzellen (MC) in einem matrixförmigen Speicherzellenfeld (1) angeordnet sind,
- die Speicherzellen (MC) zu adressierbaren Einheiten von Spaltenleitungen (BL) und Reihenleitungen (WL) zusammengefaßt sind,
- die Adressen der Speicherzellen (MC) einen ersten Adreßteil (ADR1) umfassen, über den auf die jeweilige Spaltenleitung (BL) zugegriffen wird, und einen zweiten Adreßteil (ADR2), über den auf die jeweilige Reihenleitung (WL) zugegriffen wird.

3. Integrierter Halbleiterspeicher nach Anspruch 2,
**dadurch gekennzeichnet, daß**
die Speichereinrichtung (4, 5) Registereinheiten (6) aufweist zur Speicherung jeweils eines der Adreßteile (ADR1, ADR2) einer der Adressen fehlerhafter normaler Speicherzellen, die in Form eines Schieberegisters miteinander verbunden sind.

4. Integrierter Halbleiterspeicher nach Anspruch 3,
**dadurch gekennzeichnet, daß**
- Ausgänge (61) der Registereinheiten (6) mit Eingängen (71) einer Vergleichseinrichtung (7) verbunden sind zum Vergleich zwischen den Inhalten der Registereinheiten (6),
- ein Ausgang (72) der Vergleichseinrichtung (7) verbunden ist mit dem Ausgang (31) der Vorverarbeitungseinrichtung (3) zur Ausgabe des Vergleichsergebnisses.

5. Integrierter Halbleiterspeicher nach Anspruch 4,
**dadurch gekennzeichnet, daß**
in den Registereinheiten (6) jeweils die einander entsprechenden Adreßteile (ADR2) gespeichert sind, der Vergleich der Inhalte der Registereinheiten (6) auf Übereinstimmung erfolgt, und bei Übereinstimmung der Speichervorgang der Speichereinheit (2) unterbrochen ist.

6. Integrierter Halbleiterspeicher nach einem der vorhergehenden Ansprüche,
**dadurch gekennzeichnet, daß**
der Speicher eine weitere Speichereinheit (10) zum Speichern von Adressen (ADR) von fehlerhaften normalen Speicherzellen (MC) aufweist, die mit dem Ausgang (22) der Speichereinheit (2) verbunden ist zur Übernahme einer der in der Speichereinheit (2) gespeicherten Adressen.

## Claims

1. Integrated semiconductor memory which can be subjected to a memory cell test for determining operative and defective memory cells, with
- addressable normal memory cells (MC),
- addressable redundant memory cells (RMC) for replacing one of the normal memory cells (MC),
- with a test circuit, comprising
- means for determining addresses of defective normal memory cells,
- a memory unit (2) for storing addresses (ADR) of defective normal memory cells (MC), **characterized in that** the memory unit (2) is connected to a control input (21) for controlling the storing operation of the memory unit (2) and an output (22) for ouputting the memory content, and **in that**
- a preprocessing device (3) with at least one memory device (4, 5) for storing a fixed number of addresses (ADR) of defective normal memory cells (MC), with a comparison device (7, 8) for the comparison between the addresses (ADR) stored in the memory device and with an output (31) for the outputting of an output signal (S31) according to the result of the comparison, which is connected to the control input (21) of the memory unit (2) is present.

2. Integrated semiconductor memory according to Claim 1, **characterized in that**
- the memory cells (MC) are arranged in a memory cell array (1) in matrix form,
- the memory cells (MC) are combined into addressable units of column lines (BL) and row lines (WL), and
- the addresses of the memory cells (MC) comprise a first address part (ADR1), via which the respective column line (BL) is accessed, and a second address part (ADR2), via which the respective row line (WL) is accessed.

3. Integrated semiconductor memory according to Claim 2, **characterized in that** the memory device (4, 5) has register units (6) for the storing of in each case one of the address parts (ADR1, ADR2) of one of the addresses of defective normal memory cells, which are connected to each other in the form of a shift register.

4. Integrated semiconductor memory according to Claim 3, **characterized in that**
- outputs (61) of the register units (6) are connected to inputs (71) of a comparison device (7) for the comparison between the content of the register units (6), and
- an output (72) of the comparison device (7) is connected to the output (31) of the preprocessing device (3) for outputting the result of the comparison.

5. Integrated semiconductor memory according to Claim 4, **characterized in that** the mutually corresponding address parts (ADR2) are respectively stored in the register units (6), the comparison of the content of the register units (6) to ascertain whether they coincide takes place, and if they coincide the storing operation of the memory unit (2) is interrupted.

6. Integrated semiconductor memory according to one of the preceding claims, **characterized in that** the memory has a further memory unit (10) for storing addresses (ADR) of defective normal memory cells (MC), which is connected to the output (22) of the memory unit (2) for taking over one of the addresses stored in the memory unit (2).

## Revendications

1. Mémoire intégrée à semiconducteurs, qui peut être soumise à un test de cellules de mémoire pour déterminer des cellules de mémoire aptes à fonctionner et des cellules de mémoire défectueuses, comprenant :
- des cellules (MC) normales de mémoire, qui peuvent être adressées,
- des cellules (RMC) redondantes de mémoire, qui peuvent être adressées et qui sont destinées à remplacer l'une des cellules (MC) normales de mémoire.
- un circuit de test comprenant
- des moyens de détermination d'adresses de cellules normales de mémoire, qui sont défectueuses.
- une unité (2) de mémoire destinée à mémoriser des adresses (ADR) de cellules (MC) normales de mémoire, qui sont défectueuses, **caractérisée en ce que** l'unité (2) de mémoire est reliée à une entrée (21) de commande de l'opération de mémorisation de l'unité (2) de mémoire et une sortie (22) de sortie du contenu de la mémoire, et **en ce que**
- il est prévu un dispositif (3) de prétraitement ayant au moins un dispositif (4, 5) de mémoire, d'un nombre fixé d'adresses (ADR) de cellules (MC) normales de mémoire qui sont défectueuses, un dispositif (7, 8) de comparaison entre les adresses (ADR) mémorisées dans le dispositif de mémoire, et une sortie (31) de sortie d'un signal (S31) de sortie en fonction du résultat de la comparaison, qui est reliée à l'entrée (21) de commande de l'unité (22) de mémoire.

2. Mémoire intégrée à semiconducteurs suivant la revendication 1, **caractérisée en ce que**
- les cellules (MC) de mémoire sont disposées suivant un champ (1) de cellules de mémoire en forme de matrice.
- les cellules (MC) et de mémoire sont rassemblées en des unités adressables de lignes (BL) de colonne et de lignes (WL) de rangée.
- les adresses de cellules (MC) de mémoire comprennent une première partie (ADR1) d'adresse, par laquelle on accède à la ligne (BL) respective de colonne et une deuxième partie (ADR2) d'adresse, par laquelle on accède à la ligne (WL) respective de rangée.

3. Mémoire intégrée à semiconducteurs, suivant la revendication 2, **caractérisée en ce que**
le dispositif (4, 5) de mémoire a des unités (6) à registre pour mémoriser respectivement l'une des parties (ADR1, ADR2) de l'une des adresses de cellules normales de mémoire, qui sont défectueuses, qui sont reliées entre elles sous la forme d'un registre à décalage.

4. Mémoire intégrée à semiconducteurs, suivant la revendication 3, **caractérisée en ce que**
- des sorties (61) des unités (6) à registre sont reliées à des entrées (71) d'un dispositif (16) de comparaison pour comparer entre les contenus des unités (6) à registre,
- une sortie (72) du dispositif (7) de comparaison est reliée à la sortie (31) du dispositif (3) de prétraitement pour la sortie du résultat de comparaison.

5. Mémoire intégrée à semiconducteurs suivant la revendication 4, **caractérisée en ce que**
dans les unités (6) à registre sont mémorisées respectivement les parties (ADR2) d'adresse se correspondant, la comparaison des contenus des unités (6) registre s'effectue par coïncidence et, s'il y a coïncidence, l'opération de mémorisation de l'unité (2) de mémoire est interrompue.

6. Mémoire intégrée à semiconducteurs suivant l'une des revendications précédentes, **caractérisée en ce que**
la mémoire a une autre unité (10) de mémoire, pour mémoriser des adresses (ADR) de cellules (MC) normales de mémoire, qui sont défectueuses, qui est reliée à la sortie (22) de l'unité (2) de mémoire et qui est destinée à la prise en charge de l'une des adresses mémorisées dans l'unité (2) de mémoire.
